# EUROPEAN PATENT APPLICATION

(11) **EP 4 525 051 A1**
(43) Date of publication of application: **19.03.2025**
(21) Application number: 23935098.6
(22) Date of filing: 05.12.2023
(51) Int. Cl.: H01L 31/0224, H01L 31/02, H01L 31/0232, H01L 31/18

(54) **OPTICAL SENSING DEVICE, PREPARATION METHOD AND ELECTRONIC DEVICE**

(30) Priority: 28.04.2023 CN 202310490886
(71) Applicant: Shenzhen Goodix Technology Co., Ltd., Shenzhen, Guangdong 518045 (CN)
(72) Inventor: SU, Chunhua, Shenzhen, Guangdong 518045 (CN); LI, Fulin, Shenzhen, Guangdong 518045 (CN); WEI, Ya, Shenzhen, Guangdong 518045 (CN)
(74) Representative: Kraus & Lederer PartGmbB
(86) International application number: PCT/CN2023/136319
(87) International publication number: WO 2024/221931

(57) **Abstract**

An optical sensing apparatus, a method for manufacturing an optical sensing apparatus, and an electronic device can improve the optical detection accuracy and user experience. The optical sensing apparatus includes: a sensor chip configured to receive an incident light signal for optical detection; and a transparent conductive layer provided above the sensor chip and connected to a grounding terminal of the sensor chip, where the transparent conductive layer is configured to be coupled with an electromagnetic wave in an environment, and transmit the electromagnetic wave to the grounding terminal of the sensor chip.

## Description

The present disclosure claims priority to the patent application for invention with the application number 202310490886.1 titled "OPTICAL SENSING APPARATUS, METHOD FOR MANUFACTURING OPTICAL SENSING APPARATUS, AND ELECTRONIC DEVICE" filed with the China National Intellectual Property Administration on 28 April 2023, which is incorporated herein by reference in its entirety.

### TECHNICAL FIELD

The present disclosure relates to the technical field of optical sensing, and more specifically relates to an optical sensing apparatus, a method for manufacturing an optical sensing apparatus, and an electronic device.

### BACKGROUND

At present, with the development of optical sensing apparatuses, they are increasingly widely used in electronic products, such as ambient light detection, image signal recognition, and under-display fingerprint recognition.

However, an electromagnetic wave in an environment tends to have electromagnetic induction with a metal circuit in an optical sensing apparatus, thereby generating an electromagnetic noise. This will not only cause a high operating noise of electronic products and affect the user experience, but also reduce the signal-to-noise ratio and affect the optical detection accuracy.

### SUMMARY

Embodiments of the present disclosure provide a near field communication apparatus and an electronic device, which can improve the performance of near field communication.

An embodiment of the present disclosure provides an optical sensing apparatus, a method for manufacturing an optical sensing apparatus, and an electronic device, which can improve the optical detection accuracy and user experience.

In a first aspect, an optical sensing apparatus is provided, including: a sensor chip configured to receive an incident light signal for optical detection; and a transparent conductive layer provided above the sensor chip and connected to a grounding terminal of the sensor chip.

In technical solutions of the embodiment of the present disclosure, the transparent conductive layer is provided on the sensor chip, and the transparent conductive layer is connected to the grounding terminal of the sensor chip. In this way, on the one hand, an electromagnetic wave in an environment can be coupled with the transparent conductive layer above the sensor chip, and an electromagnetic coupling noise generated therefrom can be eliminated by grounding, and on the other hand, transparency of the transparent conductive layer can allow the optical sensing apparatus to maintain an original incident light amount, thereby improving the signal-to-noise ratio, reducing the operating noise, and improving the optical detection accuracy and user experience.

In a possible embodiment, the sensor chip includes a substrate and a wiring layer provided on an upper surface of the substrate; the grounding terminal of the sensor chip is arranged at the wiring layer, and the transparent conductive layer is arranged above the wiring layer and connected to the grounding terminal.

In a possible embodiment, the sensor chip includes a substrate and a wiring layer provided on an upper surface of the substrate; the grounding terminal of the sensor chip is arranged at the substrate, and the transparent conductive layer is arranged above the wiring layer and runs through a through hole of the wiring layer for connection to the grounding terminal.

In a possible embodiment, the optical sensing apparatus further includes a first filter structure provided above the sensor chip to allow for transmittance of a visible light signal in the incident light signal and filter out an infrared light signal in the incident light signal.

When the optical sensing apparatus is applied in a scenario such as ambient light detection and image signal recognition, the first filter structure capable of filtering out the infrared light signal and allowing for transmittance of the visible light signal is arranged to reduce the interference of the infrared light signal and improve the signal-to-noise ratio.

In a possible embodiment, the first filter structure includes a first filter layer and a second filter layer stacked from bottom to top; where the first filter layer is configured to filter out the infrared light signal in the incident light signal; and the second filter layer is configured to allow for transmittance of the visible light signal in the incident light signal.

In a possible embodiment, the second filter layer includes a plurality of sub-filter layers arranged side by side to allow for transmittance of light signals in a plurality of different wavebands in the visible light signal respectively.

In a possible embodiment, when the transparent conductive layer is arranged between the first filter layer and the second filter layer; or the transparent conductive layer is arranged between the first filter layer and the sensor chip.

In a possible embodiment, when the transparent conductive layer is arranged between the first filter layer and the second filter layer, the transparent conductive layer is connected to the grounding terminal of the sensor chip along an edge of the first filter layer.

In a possible embodiment, the optical sensing apparatus further includes a second filter structure provided above the sensor chip to allow for transmittance of an infrared light signal in the incident light signal and filter out a visible light signal in the incident light signal.

When the optical sensing apparatus is applied in a scenario of automatic vending, the second filter structure capable of allowing for transmittance of the infrared light signal and filtering out the visible light signal is arranged to reduce the interference of the visible light signal and improve the signal-to-noise ratio.

In a possible embodiment, the second filter structure includes a third filter layer and a fourth filter layer stacked from bottom to top; where the third filter layer is configured to filter out the visible light signal in the incident light signal; and the fourth filter layer is configured to allow for transmittance of the infrared light signal in the incident light signal.

In a possible embodiment, when the transparent conductive layer is arranged between the third filter layer and the fourth filter layer; or the transparent conductive layer is arranged between the third filter layer and the sensor chip.

In a possible embodiment, when the transparent conductive layer is arranged between the third filter layer and the fourth filter layer, the transparent conductive layer is connected to the grounding terminal of the sensor chip along an edge of the third filter layer.

In a possible embodiment, the optical sensing apparatus further includes a first filter structure and a second filter structure arranged side by side above the sensor chip; where the first filter structure is configured to allow for transmittance of the visible light signal in the incident light signal and filter out the infrared light signal in the incident light signal; and the second filter structure is configured to allow for transmittance of the infrared light signal in the incident light signal and filter out the visible light signal in the incident light signal.

Not only is the first filter structure capable of filtering out the infrared light signal and allowing for transmittance of the visible light signal arranged above the sensor chip, but also the second filter structure capable of allowing for transmittance of the infrared light signal and filtering out the visible light signal is arranged, so as to be adapted to a variety of optical detection scenarios, such as ambient light detection, image signal recognition, and automatic vending, thereby improving the adaptability of the optical sensing apparatus.

In a possible embodiment, the first filter structure and the second filter structure are arranged above the transparent conductive layer; and the first filter structure includes a plurality of first sub-filter structures arranged side by side to allow for transmittance of light signals in a plurality of different wavebands in the visible light signal respectively.

In the embodiment, not only can the optical sensing apparatus be adapted to a variety of optical detection scenarios, but also the overall thickness of the optical sensing apparatus can be reduced, which is beneficial to achieving a thin and light electronic device equipped with the optical sensing apparatus.

In a possible embodiment, a material of the transparent conductive layer is at least one of indium tin oxide, F-doped, and amorphous silicon.

In a possible embodiment, a light transmittance of the transparent conductive layer for the incident light signal is greater than 90%. The transparent conductive layer 120 has a high light transmittance, which can reduce the attenuation of the incident light signal.

In a possible embodiment, a thickness of the transparent conductive layer is less than or equal to 100 nm. Controlling the thickness of the transparent conductive layer to be within 100 nm can ensure the light transmittance and the incident light amount of the transparent conductive layer.

In a possible embodiment, a thickness of the transparent conductive layer is 30 nm-50 nm. Setting the thickness of the transparent conductive layer to 30 nm-50 nm can balance between the light transmittance and conductivity of the transparent conductive layer.

In a possible embodiment, an impedance of the transparent conductive layer is less than or equal to 30 Ω/cm². When the impedance of the transparent conductive layer is less than or equal to 30 Ω/cm², it can ensure that the transparent conductive layer has a minimum conductive performance required to conduct the electromagnetic coupling noise to the grounding terminal.

In a possible embodiment, the transparent conductive layer is formed on the sensor chip by coating or spin coating.

In a possible embodiment, the optical sensing apparatus is used in an electronic device with a display screen and is configured to be arranged below the display screen, and the sensor chip is configured to receive the incident light signal through the display screen for under-display optical detection.

In a second aspect, a method for manufacturing an optical sensing apparatus is provided, including: providing a sensor chip configured to receive an incident light signal for optical detection; and manufacturing a transparent conductive layer above the sensor chip, where the transparent conductive layer is connected to a grounding terminal of the sensor chip.

In technical solutions of the embodiment of the present disclosure, the transparent conductive layer is manufactured on the sensor chip, and the transparent conductive layer is connected to the grounding terminal of the sensor chip. In this way, on the one hand, an electromagnetic wave in an environment can be coupled with the transparent conductive layer above the sensor chip, and an electromagnetic coupling noise generated therefrom can be eliminated by grounding, and on the other hand, transparency of the transparent conductive layer can allow the optical sensing apparatus to maintain an original incident light amount, thereby improving the signal-to-noise ratio, reducing the operating noise, and improving the optical detection accuracy and user experience.

In a possible embodiment, the sensor chip includes a substrate and a wiring layer provided on an upper surface of the substrate, and the grounding terminal of the sensor is provided at the wiring layer; and the manufacturing the transparent conductive layer above the sensor chip includes: manufacturing the transparent conductive layer above the wiring layer, where the transparent conductive layer is connected to the grounding terminal at the wiring layer.

In a possible embodiment, the sensor chip includes a substrate and a wiring layer provided on an upper surface of the substrate, the grounding terminal of the sensor chip is arranged at the substrate; and the manufacturing the transparent conductive layer above the sensor chip includes: manufacturing the transparent conductive layer above the wiring layer, where the transparent conductive layer is connected to the grounding terminal of the substrate through a through hole of the wiring layer.

In a possible embodiment, the manufacturing method further includes: manufacturing a first filter structure above the sensor chip, where the first filter structure is configured to allow for transmittance of a visible light signal in the incident light signal and filter out an infrared light signal in the incident light signal.

In a possible embodiment, the manufacturing the first filter structure above the sensor chip includes: manufacturing a first filter layer; and manufacturing a second filter layer above the first filter layer; where the first filter layer is configured to filter out the infrared light signal in the incident light signal, and the second filter layer is configured to allow for transmittance of the visible light signal in the incident light signal.

In a possible embodiment, the manufacturing the second filter layer above the first filter layer includes: manufacturing a plurality of sub-filter layers side by side, where the plurality of sub-filter layers are configured to allow for transmittance of light signals in a plurality of different wavebands in the visible light signal respectively.

In a possible embodiment, the manufacturing the transparent conductive layer above the sensor chip includes: manufacturing the transparent conductive layer on an upper surface of the sensor chip prior to the manufacturing the first filter layer; or manufacturing the transparent conductive layer on an upper surface of the first filter layer after the manufacturing the first filter layer.

In a possible embodiment, the manufacturing the transparent conductive layer above the sensor chip further includes: manufacturing the transparent conductive layer on an edge of the first filter layer, where the transparent conductive layer is connected to the grounding terminal of the sensor chip along the edge of the first filter layer.

In a possible embodiment, the manufacturing method further includes: manufacturing a second filter structure above the sensor chip, where the second filter structure is configured to allow for transmittance of an infrared light signal in the incident light signal and filter out a visible light signal in the incident light signal.

In a possible embodiment, the manufacturing the second filter structure above the sensor chip includes: manufacturing a third filter layer; and manufacturing a fourth filter layer above the third filter layer; where the third filter layer is configured to filter out the visible light signal in the incident light signal, and the fourth filter layer is configured to allow for transmittance of the infrared light signal in the incident light signal.

In a possible embodiment, the manufacturing the transparent conductive layer above the sensor chip includes: manufacturing the transparent conductive layer on an upper surface of the sensor chip prior to the manufacturing the third filter layer; or manufacturing the transparent conductive layer on an upper surface of the third filter layer after the manufacturing the third filter layer.

In a possible embodiment, the manufacturing the transparent conductive layer above the sensor chip further includes: manufacturing the transparent conductive layer on an edge of the third filter layer, where the transparent conductive layer is connected to the grounding terminal of the sensor chip along the edge of the third filter layer.

In a possible embodiment, the manufacturing method further includes: manufacturing a first filter structure and a second filter structure side by side above the sensor chip; where the first filter structure is configured to allow for transmittance of the visible light signal in the incident light signal and filter out the infrared light signal in the incident light signal; and the second filter structure is configured to allow for transmittance of the infrared light signal in the incident light signal and filter out the visible light signal in the incident light signal.

In a possible embodiment, the manufacturing the first filter structure and the second filter structure side by side above the sensor chip includes: manufacturing the first filter structure and the second filter structure above the transparent conductive layer; and the manufacturing the first filter structure above the transparent conductive layer includes: manufacturing a plurality of first sub-filter structures side by side, where the plurality of first sub-filter structures are configured to allow for transmittance of light signals in a plurality of different wavebands in the visible light signal respectively.

In a possible embodiment, the transparent conductive layer is manufactured on the sensor chip by coating or spin coating.

In a third aspect, an electronic device is provided, including: the optical sensing apparatus according to the first aspect or any one possible embodiment of the first aspect, or the optical sensing apparatus manufactured according to the second aspect or any one possible embodiment of the second aspect.

### BRIEF DESCRIPTION OF DRAWINGS

FIG. 1 is a schematic structural diagram of an optical sensing apparatus according to an embodiment of the present disclosure.
FIG. 2 is a schematic structural diagram of another optical sensing apparatus according to an embodiment of the present disclosure.
FIGS. 3 to 8 are schematic structural diagrams of several other apparatuses for recognizing an optical fingerprint according to embodiments of the present disclosure.
FIG. 9 is a flow block of a method for manufacturing an optical sensing apparatus according to an embodiment of the present disclosure.
FIGS. 10 to 12 are flow blocks of several other methods for manufacturing an optical sensing apparatus according to embodiments of the present disclosure.

### DESCRIPTION OF EMBODIMENTS

Technical solutions of embodiments of the present disclosure will be described below with reference to the drawings.

An optical sensing apparatus in an embodiment of the present disclosure can be applied to various electronic devices, and are particularly adapted to computers and peripherals thereof, communications, consumer-electronics, and other 3C electronic products, for example, smart phones, notebook computers, tablet computers, smart wearable devices, household appliances, game devices, etc. In addition, the optical sensing apparatus can be further applied to other types of electronic devices such as automotive electronics.

As an example and non-restrictively, the optical sensing apparatus in the embodiment of the present disclosure can be used in a light signal detection system, for example, ambient light detection, which can automatically adjust keyboard light, screen brightness, etc., and for another example, infrared light detection, which can achieve automatic vending, etc. The optical sensing apparatus in the embodiment of the present disclosure can also be used in an optical imaging system, such as image signal recognition, and can still be used in an optical recognition system, such as optical fingerprint recognition.

In the optical imaging system, a conventional optical sensing apparatus can partially filter out the infrared light in the incident light signal by providing an infrared filter or a color filter, thereby obtaining a light signal and an image close to responses of human eyes. However, this method can only filter out non-visible light signals in a signal source, but cannot shield electromagnetic interference. Specifically, an electromagnetic wave in an environment tends to have electromagnetic induction with a metal circuit in the optical sensing apparatus, thereby resulting in a high noise of an electronic device, affecting the user experience, reducing the signal-to-noise ratio of the signal, and affecting the optical detection accuracy.

At present, in order to reduce the impact of electromagnetic interference on the noise and the signal-to-noise ratio, one solution is to place a grounded metal grid layer on a sensor chip of the optical sensing apparatus to guide an electromagnetic wave signal to a grounding terminal through metal shielding, but this method will reduce the light transmittance area of the sensor chip and reduce an amount of incident light received by the sensor chip. In other words, this method reduces the noise, but will also reduce the signal amount, thereby unobviously improving the signal-to-noise ratio, or even reducing the signal-to-noise ratio. Another solution is to achieve electromagnetic shielding by providing a transparent conductive substrate outside a screen of the electronic device. This method consumes less incident light, but is not compatible with a wafer process, and is very difficult to interconnect with a grounding terminal of the sensor chip, thereby failing to guide away the electromagnetic wave signal with unobvious noise reduction effects.

In view of this, an embodiment of the present disclosure provides an optical sensing apparatus that can reduce the impact of the electromagnetic wave in the environment on the noise and signal-to-noise ratio, and improve the optical detection accuracy and user experience.

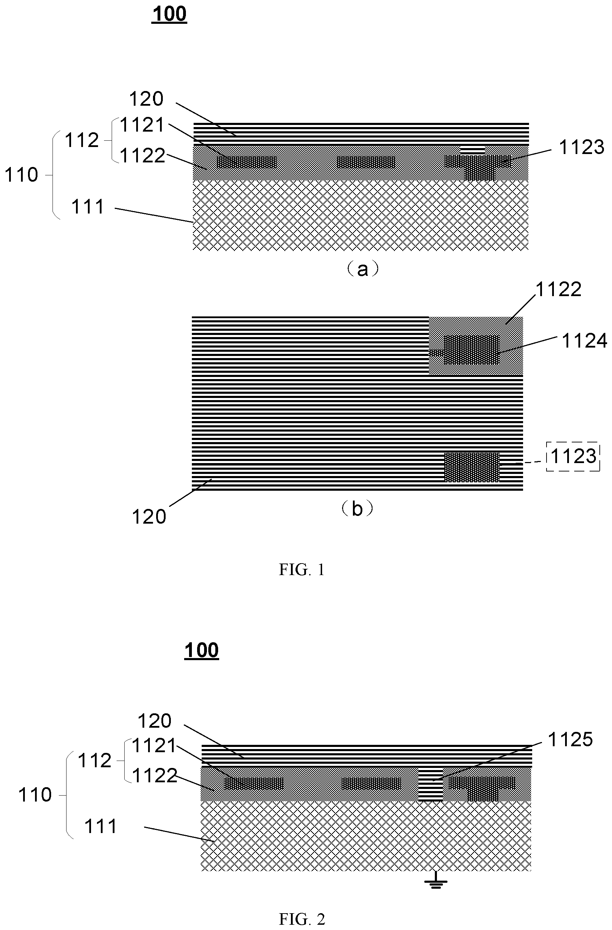

FIG. 1 is a schematic structural diagram of an optical sensing apparatus provided in an embodiment of the present disclosure. FIG. 1(a) is a principal sectional view of the optical sensing apparatus 100, and FIG. 1(b) is a top view of the optical sensing apparatus 100. As shown in FIG. 1, the optical sensing apparatus 100 includes:
a sensor chip 110 configured to receive an incident light signal for optical detection; and
a transparent conductive layer 120 provided above the sensor chip 110 and connected to a grounding terminal of the sensor chip 110.

The transparent conductive layer 120 can be configured to be coupled with an electromagnetic wave in an environment, and transmit the electromagnetic wave to the grounding terminal of the sensor chip 110. It should be noted that FIG. 1 does not show the grounding terminal of the sensor chip 110.

Therefore, in the optical sensing apparatus in the embodiment of the present disclosure, the transparent conductive layer can be provided on the sensor chip, and the transparent conductive layer is connected to the grounding terminal of the sensor chip. In this way, on the one hand, the electromagnetic wave in the environment can be coupled with the transparent conductive layer, and an electromagnetic coupling noise generated therefrom can be eliminated by grounding, and on the other hand, transparency of the transparent conductive layer can allow the optical sensing apparatus to maintain an original incident light amount, thereby improving the signal-to-noise ratio, reducing the operating noise, and improving the optical detection accuracy and user experience.

Optionally, the material of the transparent conductive layer 120 may be at least one of indium tin oxide (ITO), F-doped tin oxide (FTO), and amorphous silicon.

Optionally, a light transmittance of the transparent conductive layer 120 for the incident light signal is greater than 90%. That is to way, the transparent conductive layer 120 has a high light transmittance, which can reduce the attenuation of the incident light signal.

Optionally, a thickness of the transparent conductive layer 120 is less than or equal to 100 nm. When the thickness of the transparent conductive layer 120 is larger than 100 nm, that is, when the thickness of the transparent conductive layer 120 is too large, the light transmittance of the transparent conductive layer 120 will be reduced, thereby increasing the attenuation of the incident light signal. Therefore, controlling the thickness of the transparent conductive layer to be within 100 nm can ensure the light transmittance and incident light amount of the transparent conductive layer 120.

Optionally, the thickness of the transparent conductive layer 120 is 30 nm-50 nm. When the thickness of the transparent conductive layer 120 is too small, its resistance is large, thereby resulting in poor conductive performance, so that the noise reduction effects are not obvious. Setting the thickness of the transparent conductive layer to 30 nm-50 nm can balance between the light transmittance and conductivity of the transparent conductive layer 120.

Optionally, an impedance of the transparent conductive layer 120 is less than or equal to 30 Ω/cm². It should be understood that when the impedance of the transparent conductive layer 120 is too large, its conductive performance is poor, so that the noise reduction effects are not obvious. When the impedance of the transparent conductive layer 120 is less than or equal to 30 Ω/cm², it can ensure that the transparent conductive layer 120 has a minimum conductive performance required to conduct the electromagnetic coupling noise to the grounding terminal.

Further referring to FIG. 1(a), the sensor chip 110 in the embodiment of the present disclosure may include a substrate 111 and a wiring layer 112 provided on an upper surface of the substrate 111. The wiring layer 112 may include a metal wiring layer 1121 and an insulating layer 1122, and the metal wiring layer 1121 may be cladded by the insulating layer 1122.

In the embodiment of the present disclosure, the material of the substrate 111 may be one of silicon substrate, silicon carbide, graphene, indium gallium arsenide, glass, etc.

Optionally, in some embodiments, further referring to FIG. 1, the transparent conductive layer 120 may be provided above the wiring layer 112, and may be connected to a grounding terminal 1123 of the wiring layer 112.

As shown in FIG. 1(b), the metal wiring layer 1121 of the wiring layer 112 not only includes a metal circuit, but also includes a grounding terminal 1123 and a positive electrode 1124. The grounding terminal 1123 may also be referred to as a grounding pad, a negative electrode, a GND PAD, etc. The positive electrode 1124 may also be referred to as a positive electrode pad, a PAD, etc. Generally, the grounding terminal 1123 and the positive electrode 1124 are not covered or shielded by the insulating layer 1122, so that the grounding terminal 1123 and the positive electrode 1124 are electrically connected to a power source or other components.

It should be noted that when the transparent conductive layer 120 is connected to the grounding terminal 1123 of the wiring layer 112, it only covers or connects the grounding terminal 1123, but does not cover or connect the positive electrode 1124.

It should be further noted that the grounding terminal 1123 in FIG. 1(b) is actually covered by the transparent conductive layer 120, so that the grounding terminal 1123 is annotated with a dotted line and a dotted frame in this figure to distinguish it from the positive electrode 1124 that is not covered by the transparent conductive layer 120.

Optionally, in some embodiments, as shown in FIG. 2, the transparent conductive layer 120 may be provided above the wiring layer 112, and the wiring layer 112 has a through hole 1125, so that the transparent conductive layer 120 can be connected to the grounding terminal of the substrate 111 through the through hole 1125.

It should be noted that the grounding terminal of the substrate 111 is not shown in FIG. 2. Since the substrate 111 itself is grounded, when the transparent conductive layer 120 is connected to the substrate 111 through the through hole 1125, it is equivalent to being connected to the grounding terminal of the substrate 111.

It should be further noted that the through hole 1122 on the wiring layer 112 can run throughout the whole wiring layer 112, but will not affect connections between various components or wires of the metal wiring layer 1121.

It should be understood that by the above-mentioned manufacturing the transparent conductive layer 120 above the sensor chip 110, the impact of the electromagnetic wave in the environment on the signal-to-noise ratio can be reduced. Further, in different application scenarios, different filter structures can also be used to reduce the impact of interfering light signals on the signal-to-noise ratio.

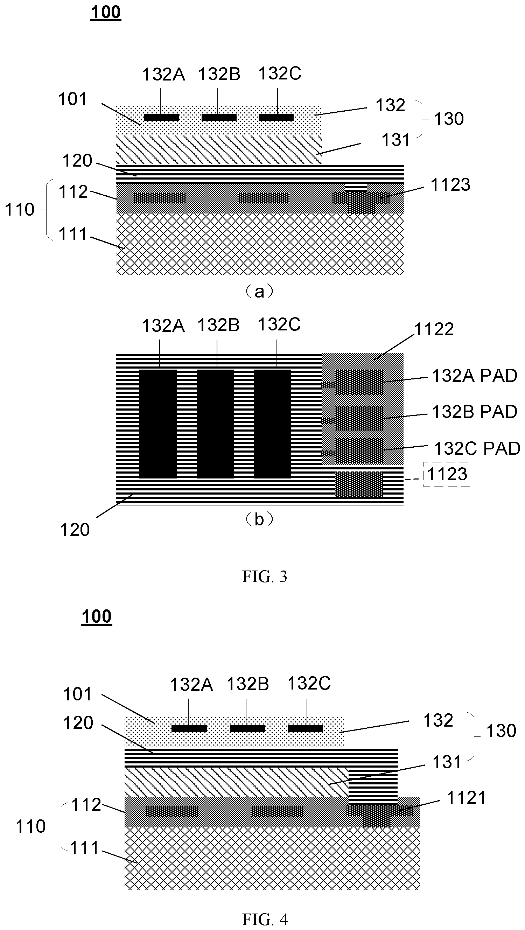

Optionally, as an embodiment, denoted as Embodiment 1, as shown in FIG. 3, the optical sensing apparatus 100 may further include a first filter structure 130, where the first filter structure 130 is provided above the sensor chip 110, to allow for transmittance of a visible light signal in the incident light signal and filter out an infrared light signal in the incident light signal.

FIG. 3(a) is a principal sectional view of the optical sensing apparatus 100, and FIG. 3(b) is a top view of the optical sensing apparatus 100.

As an example and non-restrictively, the optical sensing apparatus 100 can be applied in scenarios such as ambient light detection and image signal recognition. In such scenarios, optical detection is performed mainly using the visible light signal in the incident light signal without the need of the infrared light signal. That is to say, in such scenarios, the infrared light signal is an interference signal. Therefore, a first filter structure capable of filtering out the infrared light signal and allowing for transmittance of the visible light signal is provided above the sensor chip, to reduce the interference of the infrared light signal and improve the signal-to-noise ratio.

Embodiment 1 is described below by taking the transparent conductive layer 120 connected to the grounding terminal 1123 of the wiring layer 112 in the sensor chip 110 as an example. Of course, the transparent conductive layer 120 may also be connected to the grounding terminal of the substrate 111 in the sensor chip 110, but this connection method is not shown in the figure.

Optionally, in some embodiments, further referring to FIG. 3, the first filter structure 130 may include a first filter layer 131 and a second filter layer 132 stacked from bottom to top. The first filter layer 131 can be configured to filter out the infrared light signal in the incident light signal. The second filter layer 132 can be configured to allow for transmittance of the visible light signal in the incident light signal.

Specifically, the first filter layer 131 may be an IR-cut filter having a function of cutting off infrared light, or may be an antireflective filter film system having a function of cutting off infrared light and antireflecting visible light. The second filter layer 132 may be a color filter capable of allowing for transmittance of visible light of a specific color and absorbing visible light in other wavebands, thereby achieving color screening.

Generally, the first filter layer 131 is an inorganic substance, and the second filter layer 132 is an organic substance. Since the materials of the first filter layer 131 and the second filter layer 132 are different, they can be bonded through a transparent organic adhesive layer 101, to improve the reliability.

Optionally, in some embodiments, the second filter layer 132 may include a plurality of sub-filter layers arranged side by side to allow for transmittance of light signals in a plurality of different wavebands in the visible light signal respectively. For example, the second filter layer includes 132A, 132B, and 132C as shown in FIG. 3. The number of sub-filter layers shown in FIG. 3 is only an example, and is not restrictive.

As an example and non-restrictively, the 132A, 132B, and 132C may be a red filter, a green filter, and a blue filter respectively, which are configured to allow for transmittance for red light, green light, and blue light respectively.

As shown in FIG. 3(b), the metal wiring layer 1121 of the wiring layer 112 in the sensor chip 110 is not only provided with the grounding terminal 1123, but also provided with a positive electrode corresponding to each sub-filter layer. Positive electrodes corresponding to the sub-filter layers 132A, 132B, and 132C are 132A PAD, 132B PAD, and 132C PAD respectively.

For example, when the sub-filter layers 132A, 132B, and 132C are a red filter, a green filter, and a blue filter respectively, 132A PAD, 132B PAD, and 132C PAD are RED PAD, GREEN PAD, and BLUE PAD respectively.

Optionally, in some embodiments, further referring to FIG. 3, the transparent conductive layer 120 may be arranged between the first filter layer 131 and the sensor chip 110. More specifically, the transparent conductive layer 120 is arranged between the first filter layer 131 and the wiring layer 112. As shown in FIG. 3(b), the transparent conductive layer 120 only covers the grounding terminal 1123 of the metal wiring layer 1121, and does not cover the positive electrodes (132A PAD, 132B PAD, and 132C PAD) of the metal wiring layer 1121, so as to be connected to the grounding terminal 1123.

It should be noted that, in order to clearly show a connection relationship between the transparent conductive layer 120 and the metal wiring layer 1121, FIG. 3(b) does not show the first filter layer 131 and the transparent organic adhesive layer 101.

It should be further noted that the grounding terminal 1123 in FIG. 3(b) is actually covered by the transparent conductive layer 120, so that the grounding terminal 1123 is annotated with a dotted line and a dotted frame in this figure to distinguish it from the positive electrodes (132A PAD, 132B PAD, and 132C PAD) that are not covered by the transparent conductive layer 120.

Optionally, in some embodiments, as shown in FIG. 4, the transparent conductive layer 120 may also be arranged between the first filter layer 131 and the second filter layer 132. The transparent conductive layer 120 is an inorganic substance, and the transparent conductive layer 120 and the second filter layer 132 can be bonded through a transparent organic adhesive layer 101, to improve the reliability. In the embodiment, the transparent conductive layer 120 only covers the grounding terminal 1123 of the metal wiring layer 1121, and does not cover the positive electrode of the metal wiring layer 1121, so as to be connected to the grounding terminal 1123. FIG. 3(b) may be referred to for the specific connection method.

Specifically, when the transparent conductive layer 120 is arranged between the first filter layer 131 and the second filter layer 132, further referring to FIG. 4, the transparent conductive layer 120 may be connected to the grounding terminal 1123 of the sensor chip 110 along an edge of the first filter layer 131.

It should be understood that the positive electrode and the grounding terminal 1123 of the metal wiring layer 1121 in the sensor chip 110 are generally arranged at an edge position to facilitate connection with the power source. When the transparent conductive layer 120 is arranged between the first filter layer 131 and the second filter layer 132, the transparent conductive layer 120 is connected to the grounding terminal 1123 along the edge of the first filter layer 131 to reduce the process difficulty.

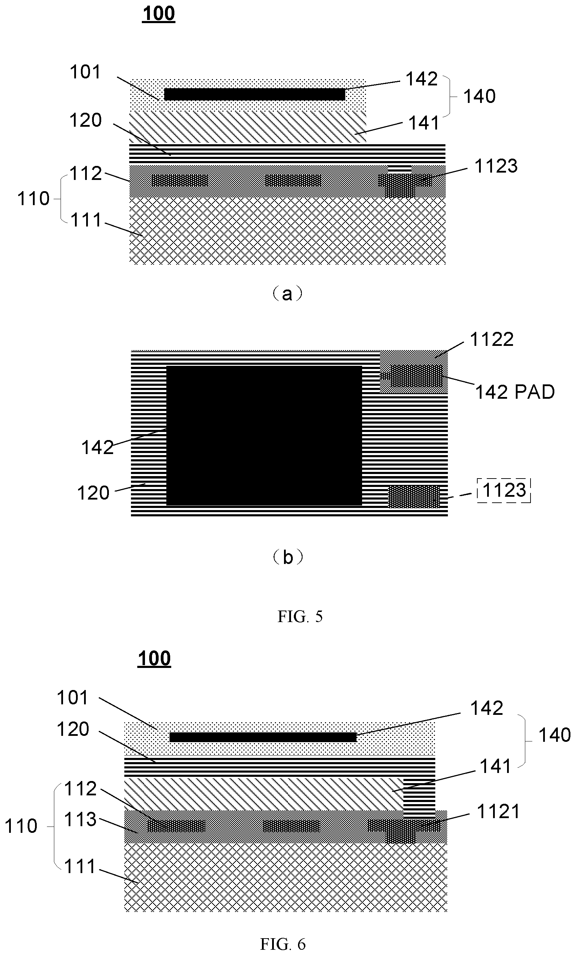

Optionally, as another embodiment, denoted as Embodiment 2, as shown in FIG. 5, the optical sensing apparatus 100 not only includes the sensor chip 110 and the transparent conductive layer 120, but also may include a second filter structure 140 provided above the sensor chip 110 to allow for transmittance of an infrared light signal in the incident light signal and filter out a visible light signal in the incident light signal.

As an example and non-restrictively, the optical sensing apparatus 100 can be applied in scenarios of automatic vending, such as automatic vending of water. In such scenarios, optical detection is performed mainly using the infrared light signal in the incident light signal. The infrared light signal may be transmitted from an infrared light source, and the visible light signal in the environment may interfere with the infrared light signal. Therefore, the second filter structure capable of allowing for transmittance of the infrared light signal and filtering out the visible light signal is provided above the sensor chip to reduce the interference with the visible light signal, and improve the signal-to-noise ratio.

Embodiment 2 is described below by taking the transparent conductive layer 120 connected to the grounding terminal 1123 of the metal wiring layer 1121 in the sensor chip 110 as an example, and of course, the transparent conductive layer 120 may also be connected to the grounding terminal of the substrate 111 in the sensor chip 110, which is not limited in the present disclosure.

Optionally, in some embodiments, as shown in FIG. 5, the second filter structure 140 may include a third filter layer 141 and a fourth filter layer 142 stacked from bottom to top. The third filter layer 141 can be configured to filter out the visible light signal in the incident light signal. The fourth filter layer 142 can be configured to allow for transmittance of the infrared light signal in the incident light signal.

FIG. 5(a) is a principal sectional view of the optical sensing apparatus 100, and FIG. 5(b) is a top view of the optical sensing apparatus 100.

Specifically, the third filter layer 141 may be a Vis-cut filter having a function of blocking or filtering out visible light. The fourth filter layer 142 may be an IR-pass color filter capable of allowing for transmittance of infrared light, and absorbing incident light in other wavebands.

Generally, the third filter layer 141 is an inorganic substance, and the fourth filter layer 142 is an organic substance. Since the materials of the third filter layer 141 and the fourth filter layer 142 are different, they can be bonded through a transparent organic adhesive layer 101, to improve the reliability.

As shown in FIG. 5(b), the metal wiring layer 1121 of the wiring layer 112 in the sensor chip 110 is not only provided with the grounding terminal 1123, but also provided with a positive electrode, namely positive electrode 142 PAD, corresponding to the fourth filter layer 142. When the fourth filter layer 142 is an IR-pass color filter, the 142 PAD is an IR PAD.

Optionally, in some embodiments, further referring to FIG. 5, the transparent conductive layer 120 may also be arranged between the third filter layer 141 and the sensor chip 110. More specifically, the transparent conductive layer 120 is arranged between the third filter layer 141 and the wiring layer 112. As shown in FIG. 5(b), the transparent conductive layer 120 only covers the grounding terminal 1123 of the metal wiring layer 1121, and does not cover the positive electrode (142 PAD) of the metal wiring layer 1121, so as to be connected to the grounding terminal 1123.

It should be noted that, in order to clearly show the connection relationship between the transparent conductive layer 120 and the metal wiring layer 1121, FIG. 5(b) does not show the third filter layer 141 and the transparent organic adhesive layer 101.

It should be further noted that the grounding terminal 1123 in FIG. 5(b) is actually covered by the transparent conductive layer 120, so that the grounding terminal 1123 is annotated with a dotted line and a dotted frame in this figure to distinguish it from the positive electrode (142 PAD) that is not covered by the transparent conductive layer 120.

Optionally, in some embodiments, as shown in FIG. 6, the transparent conductive layer 120 may also be arranged between the third filter layer 141 and the fourth filter layer 142. The transparent conductive layer 120 is an inorganic substance, and can be bonded with the fourth filter layer 142 through a transparent organic adhesive layer 101, to improve the reliability.

Specifically, further referring to FIG. 6, when the transparent conductive layer 120 is arranged between the third filter layer 141 and the fourth filter layer 142, the transparent conductive layer 120 may be connected to the grounding terminal of the sensor chip 110 along an edge of the third filter layer 141. In the embodiment, the transparent conductive layer 120 only covers the grounding terminal 1123 of the metal wiring layer 1121, and does not cover the positive electrode of the metal wiring layer 1121, so as to be connected to the grounding terminal 1123. FIG. 5(b) may be referred to for the specific connection method.

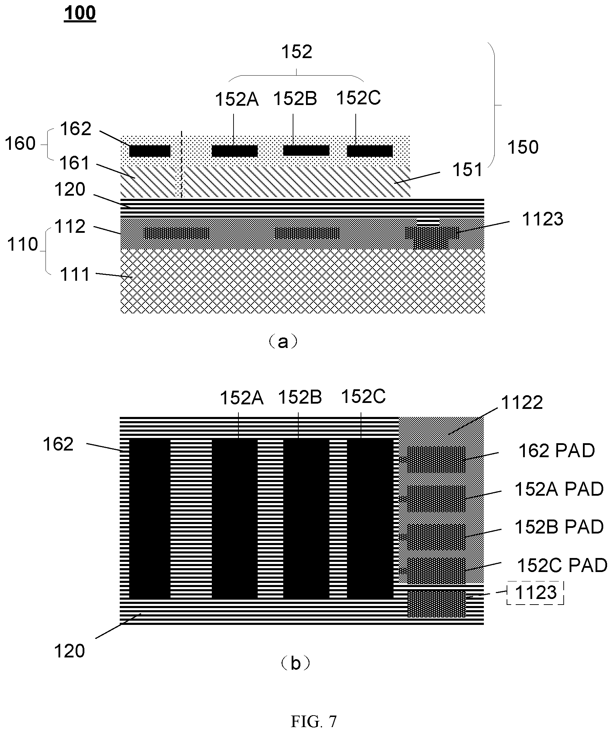

Optionally, as another embodiment, denoted as Embodiment 3, as shown in FIG. 7, the optical sensing apparatus 100 not only includes the sensor chip 110 and the transparent conductive layer 120, but also may include a first filter structure 150 and a second filter structure 160 provided side by side above the sensor chip 110. The first filter structure 150 can be configured to allow for transmittance of a visible light signal in the incident light signal and filter out an infrared light signal in the incident light signal. The second filter structure 160 can be configured to allow for transmittance of the infrared light signal in the incident light signal and filter out the visible light signal in the incident light signal. In this way, the optical sensing apparatus 100 can be adapted to a variety of light detection scenarios simultaneously, such as ambient light detection, image signal recognition, and automatic vending, thereby improving the adaptability of the optical sensing apparatus.

FIG. 7(a) is a principal sectional view of the optical sensing apparatus 100, and FIG. 7(b) is a top view of the optical sensing apparatus 100.

Specifically, as shown in FIG. 7(a), the first filter structure 150 may include a first filter layer 151 and a second filter layer 152 stacked from bottom to top, where the first filter layer 151 can be configured to filter out the infrared light signal in the incident light signal, and the second filter layer 152 can be configured to allow for transmittance of the visible light signal in the incident light signal. The second filter structure 160 may include a third filter layer 161 and a fourth filter layer 162 stacked from bottom to top, where the third filter layer 161 can be configured to filter out the visible light signal in the incident light signal, and the fourth filter layer 162 can be configured to allow for transmittance of the infrared light signal in the incident light signal.

Specifically, the first filter structure 150 may be the first filter structure 130 in Embodiment 1. The second filter structure 160 may be the second filter structure 140 in Embodiment 2. For the sake of brevity, no further details will be given in the present disclosure.

Optionally, in the Embodiment 3, the transparent conductive layer 120 may be arranged between the sensor chip 110 and the first filter structure 150, and between the sensor chip 110 and the second filter structure 160. As shown in FIG. 7(b), the transparent conductive layer 120 only covers the grounding terminal 1123 of the metal wiring layer 1121, and does not cover the positive electrodes (152A PAD, 152B PAD, 152C PAD, and 162PAD) of the metal wiring layer 1121, so as to be connected to the grounding terminal 1123.

It should be noted that, in order to clearly show the connection relationship between the transparent conductive layer 120 and the metal wiring layer 1121, FIG. 7(b) does not show the first filter layer 151 in the above first filter structure 150, the third filter layer 161 in the second filter structure 160, and the transparent organic adhesive layer 101.

It should be further noted that the grounding terminal 1123 in FIG. 5(b) is actually covered by the transparent conductive layer 120, so that the grounding terminal 1123 is annotated with a dotted line and a dotted frame in this figure to distinguish it from the positive electrodes (152A PAD, 152B PAD, 152C PAD, and 162PAD) that are not covered by the transparent conductive layer 120.

Optionally, in the Embodiment 3, the transparent conductive layer 120 may also be arranged between the first filter layer 151 and the second filter layer 152 in the first filter structure 150, and between the third filter layer 161 and the fourth filter layer 162 in the second filter structure 160. This arrangement is not shown in the figure, and FIGS. 4 and 6 may be referred to for the specific arrangement positions. In addition, in the embodiment, the transparent conductive layer 120 only covers the grounding terminal 1123 of the metal wiring layer 1121, and does not cover the positive electrode of the metal wiring layer 1121, so as to be connected to the grounding terminal 1123. FIG. 7(b) may be referred to for the specific connection method.

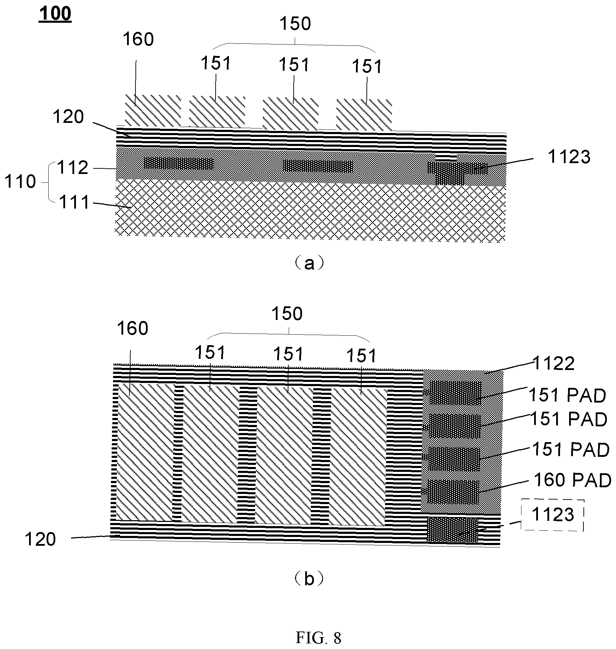

Optionally, as another embodiment, denoted as Embodiment 4, as shown in FIG. 8, the above first filter structure 150 and the above second filter structure 160 are arranged above the transparent conductive layer 120. The first filter structure 150 may include a plurality of first sub-filter structures 151 arranged side by side. The plurality of first sub-filter structures 151 are configured to allow for transmittance of light signals in a plurality of different wavebands in the visible light signal respectively, for example, 3 first sub-filter structures 151 as shown in FIG. 8. The number of first sub-filter structures 151 shown in FIG. 8 is only an example and is not restrictive. The second filter structure 160 is configured to allow for transmittance of the infrared light signal in the incident light signal and filter out the visible light signal in the incident light signal. In other words, the plurality of first sub-filter structures 151 in the first filter structure 150 and the second filter structure 160 can be configured to allow for transmittance of light signals in different wavebands respectively.

FIG. 8(a) is a principal sectional view of the optical sensing apparatus 100, and FIG. 8(b) is a top view of the optical sensing apparatus 100.

As shown in FIG. 8(b), the metal wiring layer 1121 of the wiring layer 112 in the sensor chip 110 is not only provided with the grounding terminal 1123, but also provided with positive electrodes corresponding to the first sub-filter structures 151 and the second filter structure 160 respectively. The positive electrode corresponding to the first sub-filter structure 151 is 151 PAD, and the positive electrode corresponding to the second filter structure 160 is 160 PAD.

In the embodiment, as shown in FIG. 8(b), the transparent conductive layer 120 only covers the grounding terminal 1123 of the metal wiring layer 1121, and does not cover the positive electrodes (151 PAD and 160 PAD) of the metal wiring layer 1121, so as to be connected to the grounding terminal 1123.

Hence, the optical sensing apparatus 100 in the Embodiment 4 can be adapted to a variety of light detection scenarios simultaneously as that in Embodiment 3.

Different from the above Embodiment 3, the first filter structure 150 and the second filter structure 160 in the Embodiment 4 each may be a one-layer structure. That is to say, the first filter structure 150 is not the two-layer structure (the first filter layer 151 and the second filter layer 152) in FIG. 7, and the second filter structure 160 is not the two-layer structure (the first filter layer 161 and the second filter layer 162) in FIG. 7. In other words, through this one-layer structure, the first filter structure 150 can realize a function of not only allowing for transmittance of a light signal in a target waveband in the visible light signal, but also filtering out all light signals (including the infrared light signal) except for the light signal in the target waveband in the incident light signal. Through this one-layer structure, the second filter structure 160 can realize a function of not only allowing for transmittance of the infrared light signal in the incident light signal, but also filtering out the visible light signal in the incident light signal.

In this way, compared with Embodiment 3, the Embodiment 4 is not only simultaneously adapted to a variety of optical detection scenarios such as ambient light detection, image signal recognition, and automatic vending, but also can reduce the overall thickness of the optical sensing apparatus 100, which is beneficial to realizing a thin and light electronic device equipped with the optical sensing apparatus.

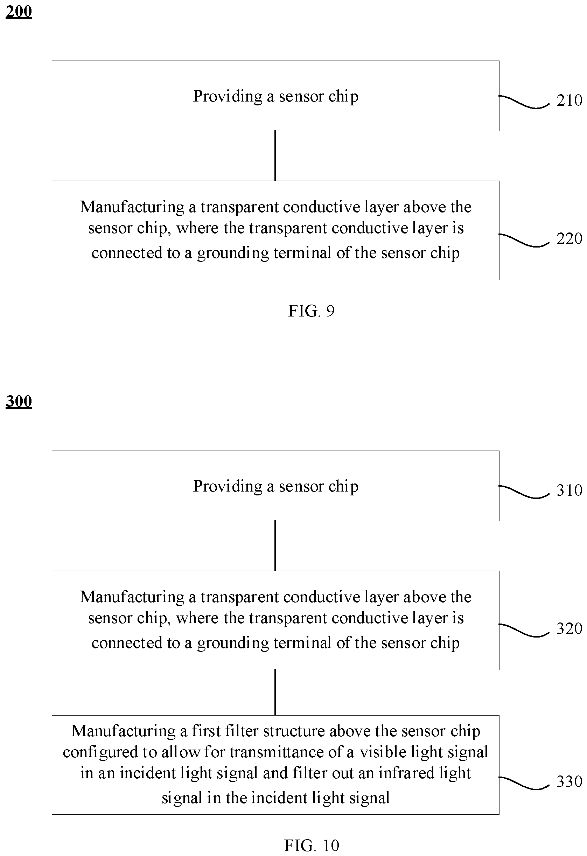

The embodiments of the optical sensing apparatus in the present disclosure are described in detail above with reference to FIGS. 1 to 8, and embodiments of a method for manufacturing an optical sensing apparatus of the present disclosure are described in detail below with reference to FIGS. 9 to 12. It should be understood that the apparatus embodiments and the method embodiments correspond to each other, and the apparatus embodiments may be referred to for similar descriptions.

FIG. 9 shows a flow block of a method 200 for manufacturing an optical sensing apparatus.

As shown in FIG. 9, the method 200 for manufacturing an optical sensing apparatus may include the following steps.

S210: providing a sensor chip 110. The sensor chip 110 is configured to receive an incident light signal for optical detection.

The sensor chip 110 in the embodiment of the present disclosure is as shown in FIGS. 1 and 2. The sensor chip 110 may include a substrate 111 and a wiring layer 112 provided on an upper surface of the substrate 111. The wiring layer 112 includes a metal wiring layer 1121 and an insulating layer 1122.

Specifically, in a process of manufacturing the sensor chip 110, an insulating layer 1122 can be manufactured on the upper surface of the substrate 111, and then the metal wiring layer 1121 can be manufactured on an upper surface of the insulating layer 1122. The insulating layer 1122 can electrically insulate the substrate 111 from the metal wiring layer 1121. Then, an insulating layer 1122 is additionally manufactured on an upper surface of the metal wiring layer 1121 to prevent the metal wiring layer 1121 from being exposed, and then obtain the sensor chip 110 with basic functions.

It should be noted that the positive electrode and the grounding terminal 1123 in the metal wiring layer 1121 are not covered by the insulating layer 1122.

In an embodiment, when an insulating layer 1122 is additionally manufactured on the upper surface of the metal wiring layer 1121, the insulating layer 1122 is manufactured only on an upper surface of the metal wiring layer 1121 except for the grounding terminal 1123 and the positive electrode, so as to expose the grounding terminal 1123 and the positive electrode.

In another embodiment, after the insulating layer 1122 is manufactured on the upper surface of the metal wiring layer 1121, a part of the insulating layer 1122 covering the positive electrode and the grounding terminal 1123 is removed by etching or other means to expose the grounding terminal 1123 and the positive electrode.

S220: manufacturing a transparent conductive layer 120 above the sensor chip 110, where the transparent conductive layer 120 is connected to a grounding terminal of the sensor chip 110.

The transparent conductive layer 120 can be configured to be coupled with an electromagnetic wave in an environment, and transmit the electromagnetic wave to the grounding terminal of the sensor chip 110.

Specifically, the transparent conductive layer 120 can be manufactured above the sensor chip 110 by coating or spin coating, and then the transparent conductive layer 120 can be connected to the grounding terminal of the sensor chip 110.

In an embodiment, the transparent conductive layer 120 may be manufactured through steps such as photoresist coating, exposure, development, indium tin oxide (ITO) deposition (ITO deposition), photoresist strip, and annealing.

In technical solutions of the present disclosure, a transparent conductive layer is manufactured on the sensor chip, and the transparent conductive layer is connected to the grounding terminal of the sensor chip. In this way, on the one hand, an electromagnetic wave in an environment can be coupled with the transparent conductive layer, and an electromagnetic coupling noise generated therefrom can be eliminated by grounding, and on the other hand, transparency of the transparent conductive layer can allow the optical sensing apparatus to maintain an original incident light amount, thereby improving the signal-to-noise ratio, reducing the operating noise, and improving the optical detection accuracy and user experience.

Optionally, in some embodiments, further referring to FIG. 1, the grounding terminal 1123 of the sensor chip 110 may be provided on the wiring layer 112, and the step S220 may specifically be: manufacturing the transparent conductive layer 120 above the wiring layer 112, where the transparent conductive layer 120 is connected to the grounding terminal 1123 exposed on the wiring layer 112. The transparent conductive layer 120 only covers the grounding terminal 1123, and does not cover the positive electrode of the metal wiring layer 1121. FIGS. 3(b), 5(b), 7(b), and 8(b) may be referred to for specific coverage or connection effects.

Optionally, in some embodiments, further referring to FIG. 2, the grounding terminal 1123 of the sensor chip 110 may be provided on the substrate 111, and the step S220 may specifically be: manufacturing the transparent conductive layer 120 above the wiring layer 112, where the transparent conductive layer 120 is connected to the grounding terminal of the substrate 111 through a through hole 1125 of the wiring layer 112.

In a specific implementation, referring to FIG. 2, the wiring layer 112 can be punched by etching to obtain the through hole 1125, where the through hole 1125 runs throughout the whole insulating layer 1122, but does not affect connections between various components or wires of the metal wiring layer 1121. Then, the transparent conductive layer 120 is manufactured in the through hole 1125 and on the wiring layer 112 by coating or spin coating, so that the transparent conductive layer 120 can be connected to the substrate 111, and then connected to the grounding terminal of the substrate 111.

FIG. 10 shows a flow block of another method 300 for manufacturing an optical sensing apparatus.

As shown in FIG. 10, the manufacturing method 300 includes S310-S330, where the S310 and the S320 are the same as the S210 and the S220 in the above-mentioned method 200 respectively, and will not be repeated here.

S330: manufacturing a first filter structure 130 above the sensor chip 110, as shown in FIGS. 3 and 4. The first filter structure 130 is configured to allow for transmittance of a visible light signal in the incident light signal and filter out an infrared light signal in the incident light signal.

Optionally, in an embodiment, the S330 may specifically include the following steps.

S331: manufacturing a first filter layer 131.

S332: manufacturing a second filter layer 132 above the first filter layer 131.

The first filter layer 131 is configured to filter out the infrared light signal in the incident light signal, and the second filter layer 132 is configured to allow for transmittance of the visible light signal in the incident light signal.

In an embodiment, referring to FIG. 3, when the S220 is specifically manufacturing the transparent conductive layer 120 on an upper surface of the sensor chip 110, the S331 is specifically forming the first filter layer 131 on an upper surface of the transparent conductive layer 120 by evaporation or sputtering, and the S332 is specifically manufacturing the second filter layer 132 on an upper surface of the first filter layer 131. That is, in the embodiment, the sequence of steps for manufacturing the optical sensing apparatus 100 is: S210, S220, S331, and S332.

It should be noted that, in the S331, the first filter layer 131 is formed on the upper surface of the transparent conductive layer 120 by evaporation or sputtering, and the first filter layer 131 is manufactured only on the upper surface of the transparent conductive layer 120 except for a region above the positive electrode and the grounding terminal 1123. In other words, the first filter layer 131 does not shield the positive electrode and the grounding terminal 1123, to prevent affecting an electrical connection between the positive electrode and the power source and an electrical connection between the grounding terminal 1123 and the power source.

The specific manufacturing process of the above S332 may be: coating an organic adhesive layer 101 on the upper surface of the first filter layer 131, then forming the second filter layer 132 on an upper surface of the organic adhesive layer 101 by evaporation or sputtering, and then coating an organic adhesive layer 101 on the second filter layer 132, to seal the second filter layer 132.

In another embodiment, referring to FIG. 4, when the S331 is specifically manufacturing the first filter layer 131 on the upper surface of the sensor chip 110, the S220 is specifically manufacturing the transparent conductive layer 120 on the upper surface of the first filter layer 131, and the S332 is specifically manufacturing the second filter layer 132 on the upper surface of the transparent conductive layer 120. That is, the sequence of steps for manufacturing the optical sensing apparatus 100 is: S210, S331, S220, and S332.

It should be noted that when the S331 is manufacturing the first filter layer 131 on the upper surface of the sensor chip 110, the first filter layer 131 is formed only on the upper surface of the sensor chip 110 except for the region above the positive electrode and the grounding terminal 1123. In other words, the first filter layer 131 does not shield the positive electrode and the grounding terminal 1123, to prevent affecting an electrical connection between the positive electrode and the power source and an electrical connection between the grounding terminal 1123 and the power source.

The specific manufacturing process of the above S332 may be: coating an organic adhesive layer 101 on the upper surface of the transparent conductive layer 120, then forming the second filter layer 132 on an upper surface of the organic adhesive layer 101 by evaporation or sputtering, and then coating an organic adhesive layer 101 on the second filter layer 132, to seal the second filter layer 132.

In the embodiment, when the transparent conductive layer 120 is manufactured on the upper surface of the first filter layer 131, the transparent conductive layer 120 can also be manufactured on an edge of the first filter layer 131, so that the transparent conductive layer 120 is connected to the grounding terminal of the sensor chip 110 along the edge of the first filter layer 131.

Optionally, in an embodiment, the S332 may specifically be: manufacturing a plurality of sub-filter layers side by side, where the plurality of sub-filter layers are configured to allow for transmittance of light signals in a plurality of different wavebands in the visible light signal respectively.

In a specific implementation, when the transparent conductive layer 120 is manufactured on the upper surface of the sensor chip 110, referring to FIG. 3, that is, the transparent conductive layer 120 is located between the sensor chip 110 and the first filter layer 131, the S332 is specifically manufacturing the plurality of sub-filter layers side by side on the upper surface of the first filter layer 131. When the transparent conductive layer 120 is manufactured on the upper surface of the first filter layer 131, referring to FIG. 4, the S332 is specifically manufacturing the plurality of sub-filter layers side by side on the upper surface of the transparent conductive layer 120.

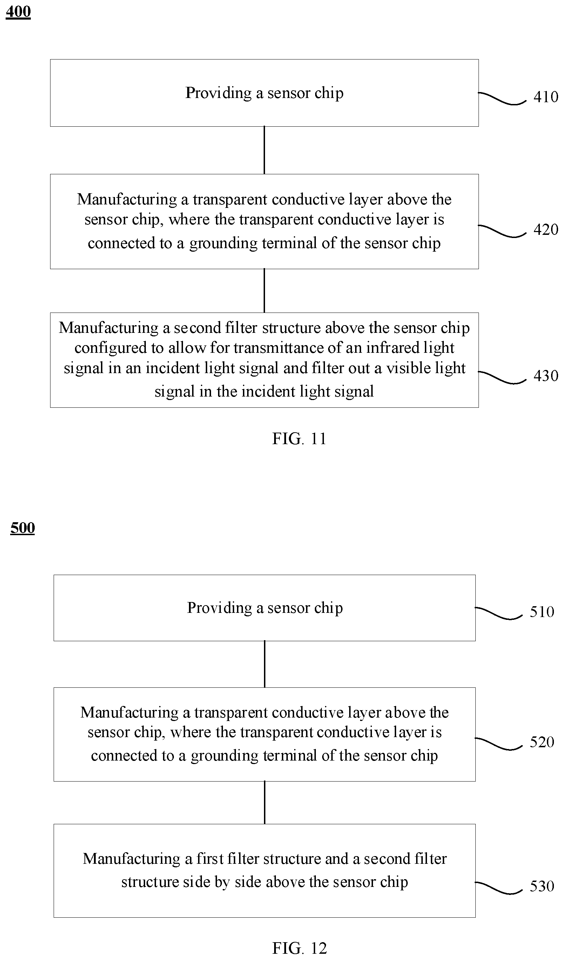

FIG. 11 shows a flow block of still another method 400 for manufacturing an optical sensing apparatus.

As shown in FIG. 11, the manufacturing method 400 includes S410-S430, where the S410 and the S420 are the same as the S210 and the S220 in the above-mentioned method 200 respectively, and will not be repeated here.

S430: manufacturing a second filter structure 140 above the sensor chip 110, as shown in FIGS. 5 and 6. The second filter structure 140 is configured to allow for transmittance of the infrared light signal in the incident light signal and filter out the visible light signal in the incident light signal.

Optionally, in some embodiments, the above S430 may include the following steps.

S431: manufacturing a third filter layer 141.

S432: manufacturing a fourth filter layer 142 above the third filter layer 141.

The third filter layer 141 is configured to filter out the visible light signal in the incident light signal, and the fourth filter layer 142 is configured to allow for transmittance of the infrared light signal in the incident light signal.

In an embodiment, referring to FIG. 5, when the S220 is specifically manufacturing the transparent conductive layer 120 on an upper surface of the sensor chip 110, the S431 is specifically forming the third filter layer 141 on an upper surface of the transparent conductive layer 120 by evaporation or sputtering, and the S432 is specifically manufacturing the fourth filter layer 142 on an upper surface of the third filter layer 141. That is, the sequence of steps for manufacturing the optical sensing apparatus 100 is: S210, S220, S431, and S432.

It should be noted that, when the S431 is forming the third filter layer 141 on the upper surface of the transparent conductive layer 120 by evaporation or sputtering, the third filter layer 141 is manufactured only on the upper surface of the transparent conductive layer 120 except for a region above the positive electrode and the grounding terminal 1123. In other words, the third filter layer 141 does not shield the positive electrode and the grounding terminal 1123, to prevent affecting an electrical connection between the positive electrode and the power source and an electrical connection between the grounding terminal 1123 and the power source.

The specific manufacturing process of the S432 may be: coating an organic adhesive layer 101 on the upper surface of the third filter layer 141, then forming the fourth filter layer 142 on an upper surface of the organic adhesive layer 101 by evaporation or sputtering, and then coating an organic adhesive layer 101 on the fourth filter layer 142, to seal the fourth filter layer 142.

In another embodiment, referring to FIG. 6, when the S431 is specifically manufacturing the third filter layer 141 on the upper surface of the sensor chip 110, the S220 is specifically manufacturing the transparent conductive layer 120 on the upper surface of the third filter layer 141, and the S432 is specifically manufacturing the fourth filter layer 142 on the upper surface of the transparent conductive layer 120. That is, the sequence of steps for manufacturing the optical sensing apparatus 100 is: S210, S431, S220, and S432.

It should be noted that when the S431 is manufacturing the third filter layer 141 on the upper surface of the sensor chip 110, the third filter layer 141 is formed only on the upper surface of the sensor chip 110 except for the region above the positive electrode and the grounding terminal 1123. In other words, the first filter layer 131 does not shield the positive electrode and the grounding terminal 1123, to prevent affecting an electrical connection between the positive electrode and the power source and an electrical connection between the grounding terminal 1123 and the power source.

The specific manufacturing process of the S432 may be: coating an organic adhesive layer 101 on the upper surface of the transparent conductive layer 120, then forming the fourth filter layer 142 on an upper surface of the organic adhesive layer 101 by evaporation or sputtering, and then coating an organic adhesive layer 101 on the fourth filter layer 142, to seal the fourth filter layer 142.

In the above embodiments, when the transparent conductive layer 120 is manufactured on the upper surface of the third filter layer 141, the transparent conductive layer 120 can also be manufactured on an edge of the third filter layer 141, so that the transparent conductive layer 120 is connected to the grounding terminal of the sensor chip 110 along the edge of the first filter layer 141.

FIG. 12 shows a flow block of yet another method 500 for manufacturing an optical sensing apparatus.

As shown in FIG. 12, the manufacturing method 500 includes S510-S530, where the S510 and the S520 are the same as the S210 and the S220 in the above-mentioned method 200 respectively, and will not be repeated here.

S530: manufacturing a first filter structure 150 and a second filter structure 160 side by side above the sensor chip 110. Referring to FIGS. 7 and 8, the first filter structure 150 is configured to allow for transmittance of a visible light signal in the incident light signal and filter out an infrared light signal in the incident light signal. The second filter structure 160 is configured to allow for transmittance of the infrared light signal in the incident light signal and filter out the visible light signal in the incident light signal.

In an embodiment, referring to FIG. 7, the above-mentioned S530 may include the following steps.

S531: manufacturing a first filter layer 151 and a third filter layer 161 side by side.

S532: manufacturing a second filter layer 152 above the first filter layer 151, and manufacturing a fourth filter layer 162 above the third filter layer 161, where the second filter layer 152 and the fourth filter layer 152 are arranged side by side.

The first filter layer 151 is configured to filter out the infrared light signal in the incident light signal, the second filter layer 152 is configured to allow for transmittance of the visible light signal in the incident light signal, the third filter layer 161 is configured to filter out the visible light signal in the incident light signal, and the fourth filter layer 162 is configured to allow for transmittance of the infrared light signal in the incident light signal.

In an embodiment, referring to FIG. 7, when the S220 is specifically manufacturing the transparent conductive layer 120 on the upper surface of the sensor chip 110, the S531 is specifically forming the first filter layer 151 and the third filter layer 161 side by side on the upper surface of the transparent conductive layer 120 by evaporation or sputtering, and the S532 is specifically manufacturing the second filter layer 152 on an upper surface of the first filter layer 151, and manufacturing the fourth filter layer 152 on an upper surface of the third filter layer 161.

It should be noted that, in the S531, the first filter layer 151 and the third filter layer 161 are formed on the upper surface of the transparent conductive layer 120 by evaporation or sputtering, and the first filter layer 151 and the third filter layer 161 are manufactured only on the upper surface of the transparent conductive layer 120 except for a region above the positive electrode and the grounding terminal 1123. In other words, the first filter layer 151 and the third filter layer 161 do not shield the positive electrode and the grounding terminal 1123, to prevent affecting an electrical connection between the positive electrode and the power source and an electrical connection between the grounding terminal 1123 and the power source.

Specifically, the forming the first filter layer 151 and the third filter layer 161 side by side on the upper surface of the transparent conductive layer 120 by evaporation or sputtering may be simultaneously forming the first filter layer 151 and the third filter layer 161 on the upper surface of the transparent conductive layer 120, or may be first forming one of them, and then manufacturing the other one, on the upper surface of the transparent conductive layer 120, which is not limited in the present disclosure. Similarly, the sequence of manufacturing the second filter layer 152 and the fourth filter layer 152 is not limited in the present disclosure.

In another embodiment, what is not shown in the figure is that the S531 is specifically forming the first filter layer 151 and the third filter layer 161 side by side on the upper surface of the sensor chip 110 by evaporation or sputtering, and the S220 is specifically manufacturing the transparent conductive layer 120 on the upper surface of the first filter layer 151 and the third filter layer 161, and the S532 is specifically manufacturing the second filter layer 152 on an upper surface of the transparent conductive layer 120 below which is the first filter layer 151, and manufacturing the fourth filter layer 152 on an upper surface of the transparent conductive layer below which is the third filter layer 161.

It should be noted that when the S531 is manufacturing the first filter layer 151 and the third filter layer 161 on the upper surface of the sensor chip 110, the first filter layer 151 and the third filter layer 161 are formed only on the upper surface of the sensor chip 110 except for the region above the positive electrode and the grounding terminal 1123. In other words, the first filter layer 151 and the third filter layer 161 do not shield the positive electrode and the grounding terminal 1123, to prevent affecting an electrical connection between the positive electrode and the power source and an electrical connection between the grounding terminal 1123 and the power source.

Optionally, in an embodiment, referring to FIG. 8, the above S530 may be manufacturing the first filter structure 150 and the second filter structure 160 side by side on the upper surface of the transparent conductive layer 120 above the sensor chip 110.

Optionally, the manufacturing the first filter structure 150 is specifically manufacturing a plurality of first sub-filter structures 151 side by side, where the plurality of first sub-filter structures 151 are configured to allow for transmittance of light signals in a plurality of different wavebands in the visible light signal respectively.

Specifically, the first filter structure 150 and the second filter structure 160 can be simultaneously manufactured side by side on the upper surface of the transparent conductive layer 120, and of course, they may also be manufactured one by one, which is not limited in the present disclosure.

An embodiment of the present disclosure further provides an electronic device, which may include the optical sensing apparatus in any one of the above embodiments or the optical sensing apparatus manufactured according to the manufacturing method in any one of the above embodiments.

It should be understood that the specific examples in the embodiments of the present disclosure are provided only to help those skilled in the art to better understand the embodiments of the present disclosure, rather than limiting the scope of the embodiments of the present disclosure.

It should be understood that the terms used in the embodiments and the appended claims of the present disclosure are intended merely to describe particular embodiments, and are not intended to limit the embodiments of the present disclosure. For example, the singular forms of "a" and "the" used in the embodiments and the appended claims of the present disclosure are also intended to include plural forms, unless the context clearly indicates other meanings.

It should be noted that the embodiments in the present disclosure and/or the technical features in the embodiments may be combined with each other in any way in case of no conflict, and the combined technical solutions should also fall into the scope of protection of the present disclosure.

For ease of description, in the embodiments of the present disclosure, same reference numerals denote same components, and for the sake of brevity, detailed descriptions of same components are omitted in different embodiments.

Unless otherwise stated, all technical terms and scientific terms used in the embodiments of the present disclosure have the same meanings as commonly understood by those skilled in the technical field of the present disclosure. The terms used in the present disclosure are only for the purpose of describing specific embodiments, and are not intended to limit the scope of the present disclosure. The term "and/or" used in the present disclosure includes any and all combinations of one or more of the associated listed items.

It should be understood that the specific examples in the embodiments of the present disclosure are provided only to help those skilled in the art to better understand the embodiments of the present disclosure, rather than limiting the scope of the embodiments of the present disclosure. Those skilled in the art may make various improvements and modifications on the basis of the above embodiments, and these improvements or modifications all fall within the scope of protection of the present disclosure.

While the above description merely provides specific embodiments of the present disclosure, the scope of protection of the present disclosure is not limited to the specific embodiments. Any person skilled in the present technical field may easily conceive of various equivalent modifications or replacements within the technical scope disclosed in the present disclosure. All these modifications or replacements should be encompassed within the scope of protection of the present disclosure. Therefore, the scope of protection of the present disclosure shall be determined by the scope of protection of the claims.

## Claims

1. An optical sensing apparatus, comprising:
a sensor chip configured to receive an incident light signal for optical detection; and
a transparent conductive layer provided above the sensor chip and connected to a grounding terminal of the sensor chip.

2. The optical sensing apparatus according to claim 1, wherein the sensor chip comprises a substrate and a wiring layer provided on an upper surface of the substrate; and
the grounding terminal of the sensor chip is provided at the wiring layer, and the transparent conductive layer is arranged above the wiring layer and connected to the grounding terminal.

3. The optical sensing apparatus according to claim 1, wherein the sensor chip comprises a substrate and a wiring layer provided on an upper surface of the substrate; and
the grounding terminal of the sensor chip is arranged at the substrate, and the transparent conductive layer is arranged above the wiring layer and runs through a through hole of the wiring layer for connection to the grounding terminal.

4. The optical sensing apparatus according to any one of claims 1 to 3, wherein the optical sensing apparatus further comprises a first filter structure provided above the sensor chip to allow for transmittance of a visible light signal in the incident light signal and filter out an infrared light signal in the incident light signal.

5. The optical sensing apparatus according to claim 4, wherein the first filter structure comprises a first filter layer and a second filter layer stacked from bottom to top;
the first filter layer is configured to filter out the infrared light signal in the incident light signal; and
the second filter layer is configured to allow for transmittance of the visible light signal in the incident light signal.

6. The optical sensing apparatus according to claim 5, wherein the second filter layer comprises a plurality of sub-filter layers arranged side by side to allow for transmittance of light signals in different wavebands of the visible light signal respectively.

7. The optical sensing apparatus according to claim 5 or 6, wherein the transparent conductive layer is arranged between the first filter layer and the second filter layer; or
the transparent conductive layer is arranged between the first filter layer and the sensor chip.

8. The optical sensing apparatus according to claim 7, wherein when the transparent conductive layer is arranged between the first filter layer and the second filter layer, the transparent conductive layer is connected to the grounding terminal of the sensor chip along an edge of the first filter layer.

9. The optical sensing apparatus according to any one of claims 1 to 3, wherein the optical sensing apparatus further comprises a second filter structure provided above the sensor chip to allow for transmittance of an infrared light signal in the incident light signal and filter out a visible light signal in the incident light signal.

10. The optical sensing apparatus according to claim 9, wherein the second filter structure comprises a third filter layer and a fourth filter layer stacked from bottom to top;
the third filter layer is configured to filter out the visible light signal in the incident light signal; and
the fourth filter layer is configured to allow for transmittance of the infrared light signal in the incident light signal.

11. The optical sensing apparatus according to claim 10, wherein the transparent conductive layer is arranged between the third filter layer and the fourth filter layer; or
the transparent conductive layer is arranged between the third filter layer and the sensor chip.

12. The optical sensing apparatus according to claim 11, wherein when the transparent conductive layer is arranged between the third filter layer and the fourth filter layer, the transparent conductive layer is connected to the grounding terminal of the sensor chip along an edge of the third filter layer.

13. The optical sensing apparatus according to any one of claims 1 to 3, wherein the optical sensing apparatus further comprises a first filter structure and a second filter structure arranged side by side above the sensor chip;
the first filter structure is configured to allow for transmittance of a visible light signal in the incident light signal and filter out an infrared light signal in the incident light signal; and
the second filter structure is configured to allow for transmittance of the infrared light signal in the incident light signal and filter out the visible light signal in the incident light signal.

14. The optical sensing apparatus according to claim 13, wherein the first filter structure and the second filter structure are arranged above the transparent conductive layer; and
the first filter structure comprises a plurality of first sub-filter structures arranged side by side to allow for transmittance of light signals in a plurality of different wavebands in the visible light signal respectively.

15. The optical sensing apparatus according to any one of claims 1 to 3, wherein a material of the transparent conductive layer is at least one of indium tin oxide, F-doped tin oxide, and amorphous silicon.

16. The optical sensing apparatus according to any one of claims 1 to 3, wherein a light transmittance of the transparent conductive layer for the incident light signal is greater than 90%;
a thickness of the transparent conductive layer is less than or equal to 100 nm; or
an impedance of the transparent conductive layer is less than or equal to 30 Ω/cm².

17. The optical sensing apparatus according to claim 16, wherein the thickness of the transparent conductive layer is 30 nm-50 nm.

18. The optical sensing apparatus according to any one of claims 1 to 3, wherein the transparent conductive layer is formed on the sensor chip by coating or spin coating.

19. The optical sensing apparatus according to any one of claims 1 to 3, wherein the optical sensing apparatus is used in an electronic device with a display screen and is configured to be arranged below the display screen, and the sensor chip is configured to receive the incident light signal through the display screen for under-display optical detection.

20. A method for manufacturing an optical sensing apparatus, comprising:
providing a sensor chip configured to receive an incident light signal for optical detection; and
manufacturing a transparent conductive layer above the sensor chip, wherein the transparent conductive layer is connected to a grounding terminal of the sensor chip.

21. The manufacturing method according to claim 20, wherein the sensor chip comprises a substrate and a wiring layer provided on an upper surface of the substrate, and the grounding terminal of the sensor chip is provided at the wiring layer; and
the manufacturing the transparent conductive layer above the sensor chip comprises:
manufacturing the transparent conductive layer above the wiring layer, wherein the transparent conductive layer is connected to the grounding terminal at the wiring layer.

22. The manufacturing method according to claim 20, wherein the sensor chip comprises a substrate and a wiring layer provided on an upper surface of the substrate, and the grounding terminal of the sensor chip is provided at the substrate; and
the manufacturing the transparent conductive layer above the sensor chip comprises:
manufacturing the transparent conductive layer above the wiring layer, wherein the transparent conductive layer is connected to the grounding terminal of the substrate through the wiring layer.

23. The manufacturing method according to any one of claims 20 to 22, wherein the manufacturing method further comprises:
manufacturing a first filter structure above the sensor chip, wherein the first filter structure is configured to allow for transmittance of a visible light signal in the incident light signal and filter out an infrared light signal in the incident light signal.

24. The manufacturing method according to claim 23, wherein the manufacturing the first filter structure above the sensor chip comprises:
manufacturing a first filter layer; and
manufacturing a second filter layer above the first filter layer;
wherein the first filter layer is configured to filter out the infrared light signal in the incident light signal, and the second filter layer is configured to allow for transmittance of the visible light signal in the incident light signal.

25. The manufacturing method according to claim 24, wherein the manufacturing the second filter layer above the first filter layer comprises:
manufacturing a plurality of sub-filter layers side by side, wherein the plurality of sub-filter layers are configured to allow for transmittance of light signals in a plurality of different wavebands in the visible light signal respectively.

26. The manufacturing method according to claim 24 or 25, wherein the manufacturing the transparent conductive layer above the sensor chip comprises:
manufacturing the transparent conductive layer on an upper surface of the sensor chip prior to manufacturing the first filter layer; or
manufacturing the transparent conductive layer on an upper surface of the first filter layer after manufacturing the first filter layer.

27. The manufacturing method according to claim 26, wherein the manufacturing the transparent conductive layer above the sensor chip further comprises:
manufacturing the transparent conductive layer on an edge of the first filter layer, wherein the transparent conductive layer is connected to the grounding terminal of the sensor chip along the edge of the first filter layer.

28. The manufacturing method according to any one of claims 20 to 22, wherein the manufacturing method further comprises:
manufacturing a second filter structure above the sensor chip, wherein the second filter structure is configured to allow for transmittance of an infrared light signal in the incident light signal and filter out a visible light signal in the incident light signal.

29. The manufacturing method according to claim 28, wherein the manufacturing the second filter structure above the sensor chip comprises:
manufacturing a third filter layer; and
manufacturing a fourth filter layer above the third filter layer;
wherein the third filter layer is configured to filter out the visible light signal in the incident light signal, and the fourth filter layer is configured to allow for transmittance of the infrared light signal in the incident light signal.

30. The manufacturing method according to claim 29, wherein the manufacturing the transparent conductive layer above the sensor chip comprises:
manufacturing the transparent conductive layer on an upper surface of the sensor chip prior to manufacturing the third filter layer; or
manufacturing the transparent conductive layer on an upper surface of the third filter layer after manufacturing the third filter layer.

31. The manufacturing method according to claim 30, wherein the manufacturing the transparent conductive layer above the sensor chip further comprises:
manufacturing the transparent conductive layer on an edge of the third filter layer, wherein the transparent conductive layer is connected to the grounding terminal of the sensor chip along the edge of the third filter layer.

32. The manufacturing method according to any one of claims 20 to 22, wherein the manufacturing method further comprises:
manufacturing a first filter structure and a second filter structure side by side above the sensor chip; wherein
the first filter structure is configured to allow for transmittance of a visible light signal in the incident light signal and filter out an infrared light signal in the incident light signal; and
the second filter structure is configured to allow for transmittance of the infrared light signal in the incident light signal and filter out the visible light signal in the incident light signal.

33. The manufacturing method according to claim 32, wherein the manufacturing the first filter structure and the second filter structure side by side above the sensor chip comprises:
manufacturing the first filter structure and the second filter structure above the transparent conductive layer; and
the manufacturing the first filter structure above the transparent conductive layer comprises:
manufacturing a plurality of first sub-filter structures side by side, wherein the plurality of first sub-filter structures are configured to allow for transmittance of light signals in a plurality of different wavebands in the visible light signal respectively.

34. The manufacturing method according to any one of claims 20 to 22, wherein the transparent conductive layer is manufactured on the sensor chip by coating or spin coating.

35. An electronic device, comprising the optical sensing apparatus according to any one of claims 1 to 19, or the optical sensing apparatus manufactured using the method for manufacturing an optical sensing apparatus according to any one of claims 20 to 34.
